# DEMANDE DE BREVET EUROPEEN

(11) **EP 2 233 615 A2**
(43) Date de publication de la demande: **29.09.2010**
(21) Numéro de dépôt: 10169399.2
(22) Date de dépôt: 04.07.2003
(51) Int. Cl.: C30B 33/00, C23C 14/04, C30B 23/00, H01L 21/04, H01L 29/04

(54) **Nano-objets metalliques, formes sur des surfaces de semiconducteurs, et procede de fabrication de ces nano-objets**

(30) Priorité: 05.07.2002 FR 0208457
(62) Demande divisionnaire de: 03762740.3
(71) Demandeur: Commissariat à l'Énergie Atomique et aux Énergies Alternatives, 75015 Paris (FR); Universite Paris Sud XI, 91405 Orsay (FR)
(72) Inventeur: D'Angelo, Marie, 75005, Paris (FR); Aristov, Victor, 142432, Moscou District (RU); Soukiassian, Patrick, 78470, Saint Remy les Chevreuses (FR)
(74) Mandataire: Ilgart, Jean-Christophe

(57) **Abrégé**

La surface comporte des zones passivées (15) et des zones non passivées (16, 18) et les nano-objets sont formés sur ces zones non passivées de la surface. L'invention s'applique en nano-électronique et permet par exemple d'obtenir des nano-objets par dépôt d'un métal sur une surface préparée de SiC cubique.

## Description

### DOMAINE TECHNIQUE

La présente invention concerne des nano-objets métalliques, formés sur des surfaces d'un semiconducteur, et plus particulièrement d'un semiconducteur ayant un grand « gap », c'est-à-dire ayant une grande largeur de bande interdite, ainsi qu'un procédé de fabrication de ces nano-objets.

L'invention concerne plus particulièrement des nano-objets métalliques, tels que, par exemple, des fils atomiques, des nano-structures unidimensionnelles et des plots quantiques (« quantum dots ») métalliques, formés en particulier sur des surfaces de carbure de silicium, ainsi qu'un procédé de fabrication de tels nano-objets.

L'invention s'applique notamment au domaine de la nano-électronique.

### ETAT DE LA TECHNIQUE ANTERIEURE

La fabrication des nano-objets se fait par auto-organisation, en particulier à température ambiante et au dessus, sans manipulation individuelle d'atomes, par exemple par microscopie en champ proche, qui se fait la plupart du temps à froid (en utilisant de l'azote liquide ou de l'hélium liquide) pour éviter la migration des atomes (voir les documents [7] à [9] cités plus loin).

En ce qui concerne le traitement de surfaces, en particulier de surfaces semiconductrices, et la fabrication de nanostructures, en particulier de nanostructures unidimensionnelles, on consultera les documents suivants :
**[1]. Electronic promotion of silicon nitridation by alkali metals**
   P. Soukiassian, H.M. Bakshi, H.I. Starnberg, Z. Hurych, T. Gentle and K.P. Schuette Physical Review Letters 59, 1488 (1987)
**[2]. CH₃CI adsorption on a Si(100)2x1 surface modified by an alkali métal overlayer studied by photoemission using synchrotron radiation**
   T.M. Gentle, P. Soukiassian, K.P. Schuette, M.H. Bakshi and Z. Hurych Surface Science Letters 202, L 568 (1988)
**[3]. Nitridation of silicon and other semiconductors using alkali metal catalysts**
   P. Soukiassian US 4 735 921 A
**[4]. Process of depositing an alkali metal layer onto the surface of an oxyde superconductor**
   P. Soukiassian and R.V. Kasowski US 4 900 710 A
**[5]. Fils atomiques de grande longueur et de grande stabilité, procédé de fabrication de ces fils, application en nanoélectronique**
   G. Dujardin, A. Mayne, F. Semond et P. Soukiassian
   Demande de brevet français N° 96 15435 du 16 décembre 1996 (voir aussi US 6 274 234 A)
**[6]. Couche monoatomique de grande taille, en carbone de type diamant, et procédé de fabrication de cette couche**
   V. Derycke, G. Dujardin, A. Mayne et P. Soukiassian
   Demande de brevet français N° 98 15218 du 2 décembre 1998
**[7].**L.J. Whitman, J.A. Stroscio, R.A. Dragoset and R.J. Celotta, Science 251, 1206 (1991**)**
**[8].**T.C. Shen, C. Wang, G.C. Abaln, J.R. Tacker, J.W. Lyding, Ph. Avouris and R.E. Walkup, Science 268, 1590 (1995)
**[9].**M.F. Crommie, C.P. Lutz, D.M. Eigler and E.J. Heller, Surf. Rev. Lett. 2, 127 (1995)

### EXPOSÉ DE L'INVENTION

La présente invention propose des nano-objets métalliques, tels que des fils atomiques, des nanostructures unidimensionnelles et des plots quantiques métalliques, qui sont susceptibles d'être très utiles dans les domaines de la nano-électronique et de l'opto-électronique.

L'invention résout en outre le problème de la fabrication de tels nano-objets sur la surface d'un semiconducteur à grand gap, notamment le carbure de silicium.

Il s'agit d'une fabrication auto-organisée sur cette surface.

Les substrats, candidats pour une telle organisation, sont les substrats pour lesquels la barrière de diffusion de surface est anisotrope en fonction d'un paramètre tel que la température, une contrainte ("stress") mécanique ......

Les nano-objets sont fabriqués grâce au contrôle de l'équilibre très délicat entre les interactions adsorbat-adsorbat et adsorbat-substrat (l'adsorbat étant le métal) et au contrôle de la barrière de diffusion des atomes du métal.

Dans un mode de réalisation particulièrement avantageux, l'invention permet d'obtenir des fils atomiques et des nano-structures d'un métal, en particulier l'argent, dont la direction est perpendiculaire à celle de lignes atomiques, ou fils atomiques, de silicium que l'on a préalablement formés sur la surface d'un substrat de carbure de silicium.

De façon précise, la présente invention concerne tout d'abord un ensemble de nano-objets, notamment de fils atomiques, de nano-structures unidimensionnelles et de plots quantiques, cet ensemble étant **caractérisé en ce que** les nano-objets sont faits d'un métal et formés sur la surface d'un substrat en un matériau semiconducteur monocristallin.

Ce matériau semiconducteur monocristallin peut être choisi parmi le carbure de silicium monocristallin, le diamant monocristallin, les semiconducteurs covalents monocristallins et les semiconducteurs composés monocristallins.

Ce substrat peut être un substrat monocristallin de carbure de silicium en phase cubique.

Selon un mode de réalisation particulier de l'ensemble, objet de l'invention, la surface est une surface de carbure de silicium cubique, riche en silicium β-SiC(100) 3x2.

Les nano-objets peuvent être des agrégats ("clusters") tridimensionnels du métal sur la surface.

Selon un mode de réalisation avantageux de l'invention, les agrégats sont répartis de façon ordonnée sur la surface et forment ainsi un réseau de plots du métal.

Selon un autre mode de réalisation particulier, la surface est une surface de carbure de silicium cubique, terminée Si β-SiC(100) c(4x2), et les nano-objets sont des fils atomiques parallèles ou des bandes unidimensionnelles nanométriques parallèles du métal.

La surface peut comporter des fils atomiques parallèles de Si, les fils atomiques et les bandes unidimensionnelles du métal étant perpendiculaires à ces fils atomiques de Si.

La surface peut comporter des zones passivées et des zones non passivées, les nano-objets étant formés sur ces zones non passivées de la surface.

La présente invention concerne aussi un procédé de fabrication d'un ensemble de nano-objets dans lequel on prépare une surface d'un substrat en un matériau semiconducteur monocristallin et l'on dépose un métal sur la surface ainsi préparée.

Ce matériau semiconducteur monocristallin peut être choisi parmi le carbure de silicium monocristallin, le diamant monocristallin, les semiconducteurs covalents monocristallins et les semiconducteurs composés monocristallins.

Ce substrat peut être un substrat monocristallin de carbure de silicium en phase cubique.

Le dépôt du métal peut être réalisé à une température supérieure à la température ambiante.

Selon un premier mode de mise en oeuvre particulier du procédé objet de l'invention, on prépare une surface de carbure de silicium cubique, riche en silicium β-SiC(100) 3x2 et l'on dépose le métal sur la surface ainsi préparée.

Selon un deuxième mode de mise en oeuvre particulier, on prépare une surface de carbure de silicium terminée Si, β-SiC(100) c(4x2). On dépose à température ambiante le métal sur la surface ainsi préparée et l'on obtient, par migration de surface des atomes de métal le long de rangées de dimères Si-Si de la surface c(4x2), des fils atomiques du métal, qui sont parallèles aux rangées de dimères Si-Si ou fils de silicium.

Ensuite, on peut effectuer un recuit thermique du substrat à une température inférieure à la température de désorption totale du métal.

On obtient ainsi des fils atomiques parallèles entre eux ou des bandes unidimensionnelles nanométriques, parallèles entre elles, du métal sur la surface. Alors, ces fils atomiques et ces bandes unidimensionnelles du métal, ainsi préparés à plus haute température, sont perpendiculaires aux fils atomiques de Si.

Le métal peut être déposé par évaporation sous vide ou dans une atmosphère inerte.

On peut former des zones passivées sur la surface préparée et déposer ensuite le métal sur des zones non passivées de cette surface.

Dans la présente invention, le métal peut être choisi parmi les métaux dont la bande d est pleine, les métaux de type jellium, les métaux alcalins (en particulier le sodium et le potassium) et les métaux de transition.

Au lieu d'utiliser un recuit thermique, on peut utiliser un laser pour obtenir la désorption de métal soit par interaction thermique du faisceau émis par ce laser sur la surface couverte de métal, soit par désorption du métal, induite par des transitions électroniques (DIET).

Dans le procédé objet de l'invention, la surface peut être une surface terminée C de type sp, à savoir la surface β-SiC (100)c(2x2).

Cette surface peut comprendre des lignes atomiques de C de type sp3.

On peut alors former, conformément à l'invention, des fils atomiques du métal, qui sont soit parallèles, soit perpendiculaires aux lignes atomiques de C.

Selon un mode de réalisation particulier de l'invention, on forme un réseau de plots du métal sur la surface du substrat en matériau semiconducteur monocristallin, on transforme localement le matériau du substrat situé sous les plots et l'on élimine le réseau de plots pour obtenir ainsi un super-réseau de plots faits du matériau transformé.

De préférence la transformation locale du matériau du substrat est choisie parmi une oxydation, une nitruration et une oxynitruration pour obtenir un super-réseau de plots faits de l'oxyde, du niture ou de l'oxynitrure du matériau.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés, sur lesquels :
- la figure 1 est une vue schématique d'agrégats tridimensionnels métalliques, obtenus conformément à l'invention,
- la figure 2 est une vue de dessus schématique de fils atomiques métalliques, obtenus conformément à l'invention et parallèles à des lignes atomiques de Si,
- la figure 3 est une vue de dessus schématique de fils atomiques métalliques et de bandes unidimensionnelles métalliques, obtenus conformément à l'invention et perpendiculaires à des lignes atomiques de Si,
- la figure 4 est une vue de dessus schématique de tels fils atomiques et bandes unidimensionnelles, obtenus conformément à l'invention, sur des zones non passivées d'une surface de carbure de silicium,

- la figure 5 est une vue schématique d'un réseau d'agrégats de sodium obtenus conformément à l'invention sur un substrat de SiC,
- la figure 6 est une vue en coupe schématique de ce substrat, portant un super-réseau de plots de silice obtenus par un procédé conforme à l'invention, et
- la figure 7 représente des photographies de LEED d'une surface propre β-SiC(100)3x2 (A), de la même surface recouverte par des agrégats de Na et organisée en réseau 3x1 (B) et de la même surface recouverte par des agrégats de Na et organisée en réseau 3x2 (C).

### EXPOSÉ DÉTAILLÉ DE MODES DE RÉALISATION PARTICULIERS

On donne maintenant un premier exemple du procédé objet de l'invention, permettant de fabriquer des agrégats d'argent.

On commence par préparer une surface de carbure de silicium cubique, riche en silicium β-SiC(100) 3x2, c'est-à-dire une surface plane de carbure de silicium SiC en phase cubique β-SiC(100) riche en silicium et ayant la reconstruction de surface 3x2.

Une telle préparation est expliquée dans divers documents mentionnés plus haut, en particulier le document [5] auquel on se reportera.

Sur cette surface riche en Si et ayant une structure 3x2, on dépose de l'argent en faible quantité par évaporation sous vide, à partir, par exemple, d'une source d'argent disposée face à la surface et chauffée par un filament de tungstène.

En formant une image de la surface par STM ou microscopie à effet tunnel ("scanning tunneling microscopy"), on constate que l'argent ne mouille pas la surface et forme des agrégats tridimensionnels dont les tailles vont de 0,9nm à 3nm et sont donc susceptibles de constituer des plots quantiques ("quantum dots").

Le nombre, la taille et l'espacement de ces agrégats ou îlots peuvent varier en fonction de la quantité d'argent déposé et des températures de recuit. Ce mode de croissance indique une interaction dominante entre atomes d'argent.

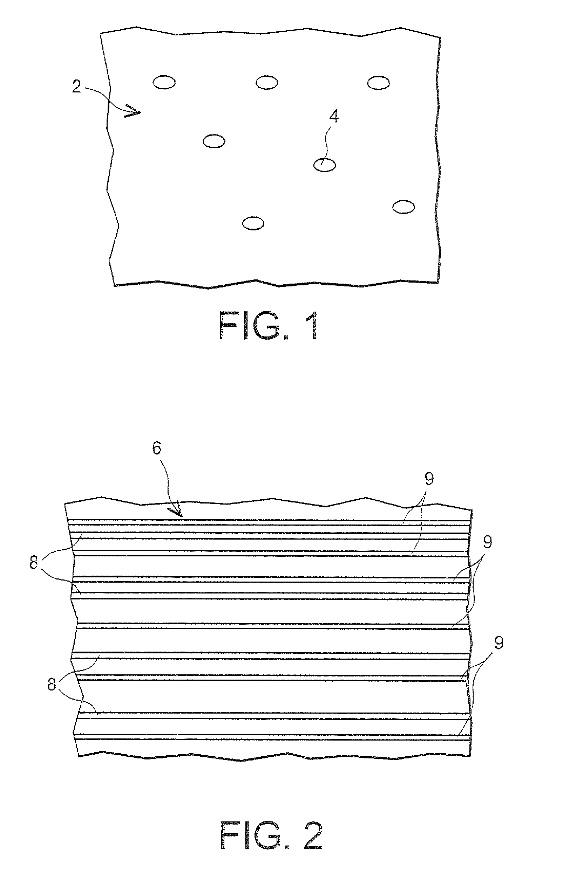

La figure 1 est une vue de dessus schématique de la surface 2 sur laquelle sont formés les agrégats 4.

A titre purement indicatif et nullement limitatif, le dépôt d'argent a lieu dans une enceinte où la pression est inférieure à 2x10⁻⁸Pa et vaut par exemple 6x10⁻⁹Pa; la distance entre la surface et la source d'argent vaut environ 15cm; le courant traversant la source d'argent pendant le dépôt vaut 4A; le temps de dépôt est compris entre 2 minutes et 8 minutes (8 minutes correspondant à environ une monocouche d'argent); le dépôt a lieu en laissant l'échantillon de SiC à température ambiante (environ 20°C). Les recuits nécessaires sont faits à environ 500°C. En faisant varier la température de recuit, on peut jouer sur la vitesse de migration des atomes de métal (la vitesse de migration augmente avec la température) et sur la quantité de métal désorbé (qui augmente avec la température) et donc jouer sur la taille des agrégats et sur leur espacement.

Il convient de noter que l'argent s'évapore complètement grâce à un court recuit à environ 700°C, pendant quelques dizaines de secondes.

On donne maintenant un deuxième exemple du procédé objet de l'invention, permettant de fabriquer des bandes unidimensionnelles d'argent ou des fils d'argent.

On commence par préparer une surface de carbure de silicium cubique, terminée Si β-SiC(100) c(4x2), c'est-à-dire une surface de SiC en phase cubique β-SiC(100), cette surface étant terminée Si et reconstruite c(4x2).

En outre, sur cette surface reposent des lignes atomiques de silicium auto-organisées qui sont parallèles, ces lignes formant des rangées de dimères Si-Si.

On se référera au document [5] où l'on explique comment obtenir des chaînes rectilignes de dimères Si-Si (lignes atomiques) à la surface d'un substrat monocristallin de SiC en phase cubique β-SiC(100) que l'on a transformé pour que sa surface soit terminée 3x2 puis que l'on a convenablement recuit.

Alors, par des recuits thermiques à 1100°C, on transforme cette surface de symétrie 3x2 jusqu'à ce qu'elle présente une organisation à l'échelle atomique (reconstruction) de symétrie c(4x2).

Sur la surface Si β-SiC(100) c(4x2) ainsi obtenue, on dépose de l'argent dans les mêmes conditions que dans le premier exemple.

On constate que, à la température ambiante, les atomes d'argent diffusent lentement sur la surface, le long des rangées de dimères, en donnant des fils atomiques du métal, parallèles à ces rangées.

La figure 2 est une vue de dessus schématique de la surface 6 portant les rangées parallèles 8 de dimères Si-Si et les fils atomiques du métal 9, qui sont parallèles à ces rangées.

Quand la surface est couverte d'argent, on procède à un recuit en dessous de la température de désorption totale de l'argent (700°C).

La couche d'argent est désorbée de façon sélective et les atomes restant sur la surface s'organisent pour faire des bandes unidimensionnelles parallèles d'argent, de taille nanométrique, ou des fils atomiques parallèles d'argent. La direction de ces fils atomiques et de ces bandes unidimensionnelles est perpendiculaire aux rangées de dimères.

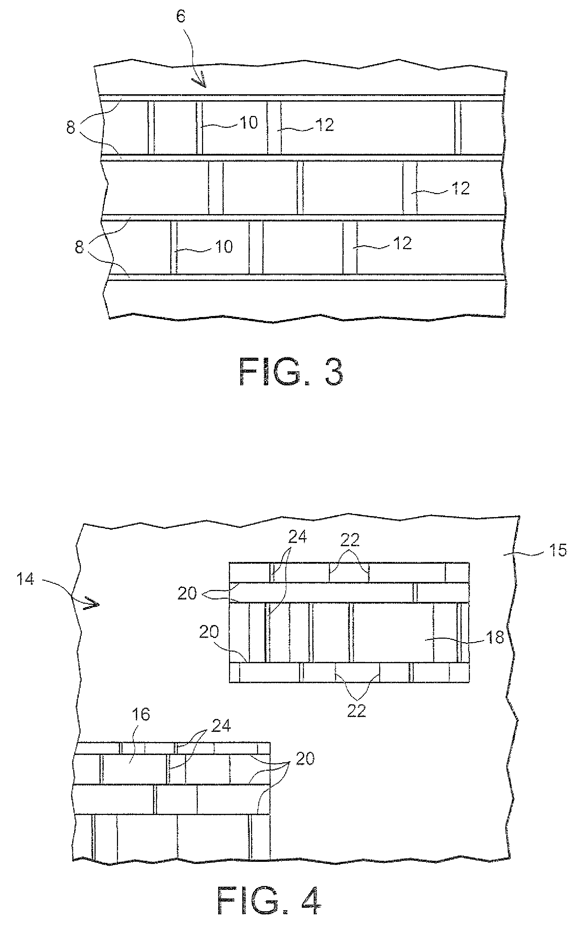

La figure 3 est une vue de dessus schématique de la surface 6 portant les rangées parallèles 8 de dimères Si-Si et les fils atomiques d'argent 10 ainsi que les bandes unidimensionnelles nanométriques d'argent 12.

A titre purement indicatif et nullement limitatif, dans ce deuxième exemple le dépôt d'argent a lieu dans une enceinte où la pression vaut 2,1x10⁻⁹Pa; l'argent est déposé pendant 8 minutes au moyen d'une source d'argent traversée par courant de 4A; pendant le dépôt d'argent, l'échantillon est laissé à la température ambiante; après le dépôt, le recuit de l'échantillon a lieu en faisant traverser ce dernier par un courant de 0,5A pendant 5 minutes.

En conséquence, on peut construire des fils d'argent perpendiculairement aux fils atomiques de Si (voir le document [5]).

Ceci est extrêmement important pour construire des réseaux artificiels à l'échelle sous nano-métrique, qui peuvent être très utiles en nano-électronique.

On peut remplacer l'argent par d'autres métaux à bande d pleine, tels que l'or ou le cuivre, ou par des métaux de type jellium, tels que l'aluminium.

On rappelle qu'un métal de type jellium est un métal dont le gaz d'électrons est sensiblement homogène et dont les charges ioniques positives sont sensiblement "étalées" ("smeared") dans la totalité du volume du métal pour donner un fond ("background") positif et uniforme.

On peut aussi remplacer l'argent par des métaux de transition tel que Mo, W, Ta, Nb, Co, Fe, Mn, Cr, Ti par exemple.

Avec les métaux ayant des caractéristiques magnétiques, l'invention permet de doper ou de fabriquer des nanostructures ayant, par exemple, des propriétés magnétiques intéressantes en électronique de spin.

On peut aussi remplacer l'argent par d'autres métaux tels que les métaux alcalins, qui sont des catalyseurs remarquables pour les réactions de surface avec des molécules organiques ou inorganiques (voir les documents [1] et [2]).

On peut donc provoquer des réactions à l'échelle atomique et favoriser une passivation très localisée, par exemple par oxydation, nitruration ou oxynitruration, ou une fabrication de silicones aux échelles atomiques ou moléculaires.

Les métaux alcalins ont aussi la propriété remarquable d'abaisser considérablement le travail de sortie des électrons, et d'atteindre le régime d'électro-affinité négative, c'est-à-dire de constituer des émetteurs naturels d'électrons. La présente invention permet à cette émission de se faire à partir de nanostructures de métaux alcalins (Cs, Rb, K ou Na par exemple).

Au lieu d'utiliser une évaporation sous vide pour déposer le métal, on peut faire cette évaporation à plus haute pression, dans une atmosphère inerte (gaz rare, etc ......).

En ce qui concerne le deuxième exemple, on précise que le procédé objet de l'invention permet de contrôler sélectivement la migration ou la désorption des atomes du métal (par exemple l'argent) en agissant sur la température. Une variation de cette dernière agit sur le mouvement des dimères Si-Si sur SiC ou provoque ce mouvement.

Dans une variante de ce deuxième exemple, on prépare la surface de SiC cubique, terminée Si β-SiC(100) c(4x2) et sans les lignes atomiques de silicium, on dépose le métal et l'on fait le recuit en dessous de la température de désorption totale du métal.

On obtient ainsi, comme précédemment, des fils atomiques du métal et/ou des bandes unidimensionnelles nanométriques de ce métal. Ces fils atomiques et ces bandes unidimensionnelles sont parallèles les uns aux autres et sont perpendiculaires à la direction selon laquelle on formerait les rangées parallèles de dimères Si-Si.

Dans un autre exemple de l'invention, on passive localement une surface préparée d'un échantillon de SiC cubique au moyen d'hydrogène et l'on forme les fils atomiques et/ou les bandes unidimensionnelles du métal dans les zones non passivées.

La figure 4 est une vue de dessus schématique de la surface 14 passivée localement et comportant ainsi des zones passivées, telle que la zone 15, et des zones non passivées 16 et 18. Les lignes atomiques parallèles de silicium, qui sont présentes dans ces zones 16 et 18, ont la référence 20. On voit aussi les fils atomiques 22 de métal et les bandes unidimensionnelles 24 de ce métal, qui sont formés dans ces zones, perpendiculairement aux lignes 20.

Pour passiver localement la surface, on recouvre les zones que l'on ne veut pas passiver d'une couche de résine photosensible ("photoresist layer") et l'on élimine cette dernière après passivation des zones non recouvertes.

Connaissant a priori la direction des rangées de dimères Si-Si, il est possible de former des zones rectangulaires non passivées dont l'un des côtés est parallèle à cette direction.

Pour passiver la surface du SiC cubique en utilisant de l'hydrogène, cette surface est préparée afin de présenter, à l'échelle atomique, une organisation contrôlée de symétrie c(4x2). Cette surface est ensuite exposée à de l'hydrogène moléculaire jusqu'à saturation. Lors de l'exposition à l'hydrogène moléculaire, le SiC est maintenu à température ambiante.

A titre d'exemple, le SiC cubique est placé dans une enceinte de traitement, dans laquelle règne une pression inférieure à 5x10⁻¹⁰ hPa, et chauffé par passage d'un courant électrique directement dans ce substrat de SiC. Ce dernier est chauffé pendant plusieurs heures à 650°C puis porté plusieurs fois à 1100°C pendant une minute.

A l'aide d'une source de silicium chauffée à 1300°C, on dépose plusieurs monocouches de silicium sur la surface (100) du SiC cubique.

A l'aide de recuits thermiques à 1000°C, on évapore, de façon contrôlée, une partie du silicium déposé jusqu'à ce que la surface présente une organisation à l'échelle atomique (reconstruction) de symétrie 3x2. Cette symétrie de la surface peut être contrôlée par diffraction d'électrons.

Au moyen de recuits thermiques à 1100°C, on transforme la surface de symétrie 3x2 jusqu'à ce qu'elle présente une organisation à l'échelle atomique (reconstruction) de symétrie c(4x2).

On expose ensuite cette surface à l'hydrogène moléculaire ultra pur à basse pression (10⁻⁸ hPa).

Au cours de cette exposition, la surface est maintenue à température ambiante.

La surface de SiC est exposée jusqu'à saturation (supérieure à 50L).

Cette saturation peut être contrôlée par un microscope à effet tunnel ou par une technique de photoémission de bande de valence.

Au lieu d'utiliser une surface terminée Si, l'ensemble des procédés précédemment décrits peuvent être également mis en oeuvre sur une surface terminée C de type sp, la surface β-SiC(100)c(2x2), qui peut elle-même comprendre des lignes atomiques de C de type sp3 (voir le document [6]).

On peut ainsi former, conformément à l'invention, des fils atomiques de métal, qui sont soit parallèles soit perpendiculaires aux lignes atomiques de carbone.

On considère dans ce qui suit d'autres exemples de la présente invention, à savoir :
- l'obtention d'agrégats de sodium sur la surface d'un substrat semiconducteur, notamment un substrat monocristallin de carbure de silicium en phase cubique,
- plus particulièrement, l'obtention de tels agrégats, répartis de façon ordonnée à la surface de ce substrat et formant ainsi un super-réseau (« super-lattice ») de plots de sodium, du genre de l'ensemble des agrégats de la figure 1 où la répartition des agrégats est sensiblement régulière, et
- l'obtention d'un super-réseau(« super-lattice ») de plots de silice sur le substrat (rappelons que l'on a déjà donné plus haut des exemples de l'invention, relatifs à la passivation localisée à l'aide de métaux alcalins).

On a étudié le dépôt de sodium sur le β-SiC(100) 3x2, qui est la surface riche en Si du carbure de silicium cubique. Contrairement au cas de la surface terminée Si β-SiC(100) c(4x2), sur laquelle l'adsorption de Na et d'autres métaux alcalins se fait sous la forme d'un film métallique, ayant une épaisseur approximativement égale à la taille d'un atome, l'adsorption de Na se fait ici sous la forme d'agrégats métalliques de forme sphérique, ce qui est sans précédent pour un métal alcalin sur la surface d'un semiconducteur. En effet, cela ne se produit pas sur les surfaces correspondantes de silicium ou de semiconducteurs composés III-V classiques (ne comprenant donc pas les nitrures III-V). Cela indique que, sur cette surface riche en Si, l'interaction adsorbat-adsorbat est plus importante que l'interaction adsorbat-substrat. Ce comportement est à rapprocher du comportement de l'argent sur la même surface (voir plus haut).

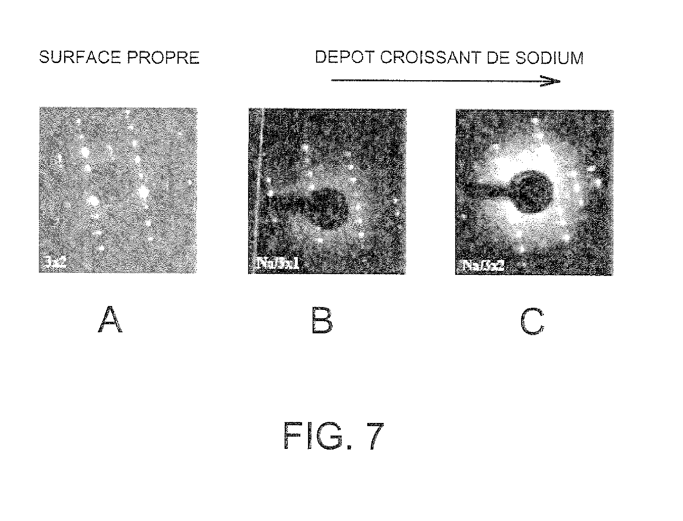

Les agrégats de Na sont identifiés grâce à un plasmon à 3,1 eV qui correspond exactement à l'énergie d'agrégats sphériques de Na. Des résultats suggèrent aussi que les agrégats de sodium sont régulièrement espacés et que leur taille tend à diminuer quand leur taux de couverture augmente. En effet, pour les dépôts les plus importants (de l'ordre de la monocouche atomique jusqu'à plusieurs monocouches atomiques) et après des recuits progressifs jusqu'à 350°C, le diagramme de diffraction d'électrons lents devient très contrasté, montrant ainsi que les agrégats de Na sont bien organisés et régulièrement espacés sur la surface β-SiC(100) 3x2. On a d'ailleurs fait des clichés des agrégats de sodium sur le β-SiC(100) 3x2 par LEED, c'est-à-dire par diffraction d'électrons de faible énergie (« low energy électron diffraction »). Ces clichés montrent que ces agrégats de Na sont bien ordonnés et régulièrement espacés, avec des ordres différents et donc des espacements différents en fonction du taux de couverture de la surface. On se reportera aux clichés de la figure 7.

On forme ainsi des plots quantiques de Na auto-organisés en jouant sur l'équilibre entre interactions adsorbat-adsorbat et adsorbat-substrat, par contrôle de la température et de la quantité de métal déposé. Ce résultat est très important et les plots obtenus diffèrent de façon très significative d'autres plots quantiques de par les propriétés intrinsèques des métaux alcalins tels que le sodium.

D'une part, ces plots sont fabriqués sur la surface d'un semiconducteur, ce qui est sans précédent, et qui plus est, il s'agit d'un semiconducteur à grand gap.

D'autre part, les métaux alcalins tels que le Na ont une très faible électroaffinité. Ils abaissent considérablement, de plusieurs électronvolts, le travail de sortie (« work function ») de la surface et l'on peut arriver à un régime d'électroaffinité négative (avec la surface seule ou exposée à de l'oxygène), c'est-à-dire à un émetteur naturel d'électrons, ou à un émetteur de photoélectrons quand le système est exposé à la lumière. Un phénomène comparable est utilisé pour la fabrication d'amplificateurs de lumière dans les dispositifs de vision nocturne à partir de surfaces d'arséniure de gallium recouvertes de Cs et d'oxygène.

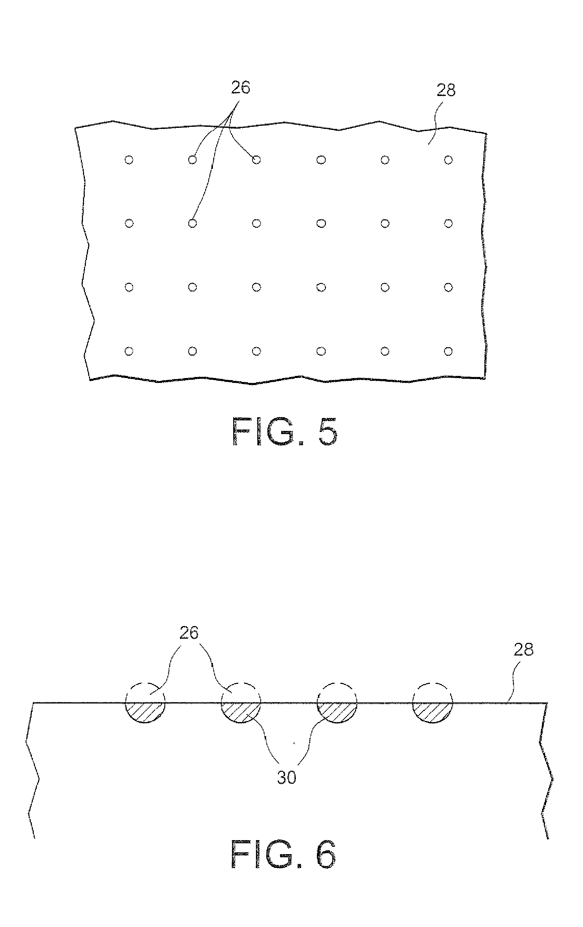

L'importance du résultat mentionné plus haut (obtention du réseau de plots quantiques de Na) provient du fait que l'on dispose d'un réseau de plots (agrégats) 26 de Na (voir figure 5), de taille nanométrique ou sub-nanométrique, qui sont régulièrement répartis sur la surface d'un substrat 28 fait d'un matériau semiconducteur à grand gap et laissent entre eux la surface nue du SiC.

Ces plots sont donc capables d'émettre des électrons sous l'effet d'une tension de polarisation ou sous l'influence de la lumière. Cela permet de former des matrices actives pour la fabrication d'écrans plats.

Une autre caractéristique importante des métaux alcalins, en particulier le sodium, réside dans leurs propriétés exceptionnelles en tant que catalyseurs d'oxydation, de nitruration, d'oxynitruration, et de réaction avec des molécules organiques.

Ces propriétés ont été mises en évidence lors de travaux sur le silicium, sur les semiconducteurs III-V, sur des métaux tels que l'aluminium et sur le SiC. On se reportera aux documents [10] à [23], qui sont mentionnés à la fin de la présente description, et aux documents [3] et [4] qui sont mentionnés plus haut.

Cela ouvre un nouveau champ d'applications, qui est très vaste et que l'on pourrait appeler « nano-lithographie » ou « nano-fabrication ». En effet, grâce à ces plots de Na, on peut, par exposition à l'oxygène (respectivement à l'azote), faire une oxydation (respectivement une nitruration) localisée de la partie du substrat 28 de SiC (voir figure 6), qui est située en dessous de chaque agrégat de Na, puis éliminer chacun de ces agrégats 26 par désorption thermique à basse température (environ 650°C). On obtient ainsi un super-réseau de plots 30 de SiO₂ (respectivement de Si₃N₄) à l'échelle nanométrique.

De même, on peut procéder à une oxynitruration localisée de cette partie du substrat de SiC, en exposant la surface couverte d'agrégats de Na à NO ou N₂O (expositions à de faibles quantités, typiquement de l'ordre de quelques langmuirs), puis éliminer les agrégats par désorption thermique en se plaçant à la température de désorption du Na sur le substrat considéré.

De la même façon, avec des molécules organiques, par exemple des molécules de CH₃Cl, on peut fabriquer des plots nanométriques de silicone et, avec d'autres molécules, on peut fabriquer d'autres plots tels que des plots de polymères et des plots d'organométalliques : il suffit d'exposer la surface aux molécules pour obtenir, sous chacun des plots de sodium, les plots de silicone ou de polymères ou d'organométalliques, puis d'éliminer les plots de sodium.

Les plots de polymères (respectivement d'organométalliques), dont il est question ci-dessus, peuvent aussi servir de points d'ancrage, sur la surface où ils sont formés, pour les molécules ayant permis de former ces plots.

Enfin, on peut aussi contrôler/optimiser l'interaction Na-Na en exposant la surface pourvue des plots de Na à de faibles quantités (environ de l'ordre du langmuir) de molécules inorganiques ou organiques (par exemple l'hydrogène, l'oxygène, ou toute autre molécule ou élément connu par l'homme du métier comme étant capable d'interagir avec le Na ou les métaux alcalins). Ceci conduira à la formation d'agrégats de Na de taille plus importante.

On explique dans ce qui suit comment obtenir les plots quantiques de sodium.

Pour ce qui concerne la préparation d'un échantillon ayant une surface de β-SiC(100) 3x2, on se référera notamment au document [5].

Un échantillon ainsi préparé est alors placé dans une enceinte à vide. Dans cette dernière, on établit une pression d'environ 10⁻⁹ Pa. On dépose ensuite du sodium sur l'échantillon grâce à une source à zéolithe, du genre de celles qui sont commercialisées par la Société SAES Getters, après avoir parfaitement dégazé cette source, de façon que l'augmentation de pression dans l'enceinte pendant le dépôt ne dépasse pas 3x10⁻⁹ Pa. On obtient ainsi des agrégats de sodium sur la surface.

Le dépôt a lieu à température ambiante (environ 25°C) et la source de Na est placée à moins de 10 cm de l'échantillon, de préférence à une distance de 3 cm à 5 cm environ de cet échantillon, la distance optimale étant d'environ 3 cm.

On procède ensuite à des recuits (à des températures de quelques centaines de degrés, par exemple 350°C, pendant une durée de quelques secondes à quelques minutes) de la surface de β-SiC(100) 3x2 recouverte des agrégats de sodium. Ces recuits permettent d'optimiser le nombre, la taille et la position de ces agrégats. Ils peuvent se faire par effet Joule, en faisant passer un courant électrique à travers l'échantillon de SiC et en contrôlant la température de ce dernier au moyen d'un pyromètre ou d'un thermocouple par exemple.

Dans les exemples donnés ci-dessus, on a utilisé le sodium pour former les agrégats. Cependant, on pourrait remplacer le sodium par d'autres métaux alcalins, plus particulièrement le potassium, le Cs, le Rb ou des métaux alcalino-terreux tels que Mg, Ca et Ba par exemple.

De plus, dans ces exemples, on a utilisé un substrat en SiC, celui-ci pouvant être, dans le cadre de la présente invention, de type cubique ou hexagonal, riche en Si et/ou en C. Cependant, on pourrait remplacer ce substrat par un substrat en diamant ou par un substrat fait d'un matériau semiconducteur covalent, par exemple le Si ou le Ge, ou par un substrat fait d'un matériau semiconducteur composé III-V (par exemple GaAs, InP, GaSb, GaP ou InAs) ou II-VI (par exemple CdTe, ZnO ou ZnTe).

En outre, la désorption thermique à basse température, dont il a été question plus haut, peut être mise en oeuvre dans une gamme de températures allant de la température ambiante (environ 25°C) jusqu'à la température de désorption du métal considéré sur le substrat considéré.

Les documents dont il a été question plus haut sont les suivants :
[10] **SiO₂-Si interface formation by catalytic oxidation using alkali metals and removal of the catalyst**
   P. Soukiassian, T.M. Gentle, M.H. Bakshi and Z. Hurych Journal of Applied Physics 60, 4339 (1986)
[11] **Exceptionally large enhancement of InP(110) oxidation rate by cesium catalyst** P. Soukiassian, M.H. Bakshi and Z. Hurych Journal of Applied Physics 61, 2679 (1987)
[12] **Catalytic oxidation of semiconductors by alkali metals**
   P. Soukiassian, T.M. Gentle, M.H. Bakshi, A.S. Bommannavar and Z. Hurych Physica Scripta (Suède), 35, 757 (1987)
[13] **Electronic promoters and semiconductor oxidation: alkali metals on Si(111)2x1 surface**
   A. Franciosi, P. Soukiassian, P. Philip, S. Chang, A. Wall, A. Raisanen and N. Troullier Physical Review B 35, Rapid Communication, 910 (1987)
[14] **Si₃N₄-Si interface formation by catalytic nitridation using alkali metals overlayers and removal of the catalyst: N_{2/}Na/Si(100)2x1**
   P. Soukiassian, T.M. Gentle, K.P. Schuette, M.H. Bakshi and Z. Hurych Applied Physics Letters 51, 346 (1987)
[15] **Electronic properties of O₂ on Cs or Na overlayers adsorbed on Si(100)2x1 from room temperature to 650° C**
   P. Soukiassian, M.H. Bakshi, Z. Hurych and T.M. Gentle Physical Review B 35, Rapid Communication, 4176 (1987)
[16] **Thermal growth of SiO₂-Si interfaces on a Si(111)7x7 surface modified by cesium** H.I. Starnberg, P. Soukiassian, M.H. Bakshi and Z. Hurych Physical Review B 37, 1315 (1988)
[17] **Alkali metal promoted oxidation of the Si(100)2x1 surface: coverage dependence and non-locality**
   H.I. Starnberg, P. Soukiassian and Z. Hurych Physical Review B 39, 12775 (1989)
[18] **Alkali metals and semiconductor surfaces: electronic, structural and catalytic properties**
   P. Soukiassian and H.I. Starnberg (Article Invité) dans Physics and Chemistry of Alkali Metal Adsorption, Elsevier Science Publishers B.V., Amsterdam, Pays Bas, Materials Science Monographs 57, 449 (1989)
[19] **Catalytic nitridation of a III-V semiconductor using alkali metal**
   P. Soukiassian, T. Kendelewicz, H.I. Starnberg, M.H. Bakshi and Z. Hurych Europhysics Letters 12, 87 (1990)
[20] **Room temperature nitridation of gallium arsenide using alkali metal and molecular nitrogen**
   P. Soukiassian, H.I. Starnberg, T. Kendelewicz and Z.D. Hurych Physical Review B 42, Rapid Communication 3769 (1990)
[21] **Rb and K promoted nitridation of cleaved GaAs and InP surfaces at room temperature**
   P. Soukiassian, H.I. Starnberg and T. Kendelewicz Applied Surface Science 56, 772 (1992)
[22] **Al₂O₃+x/Al interface formation by promoted oxidation using an alkali metal and removal of the catalyst**
   Y. Huttel, E. Bourdié, P. Soukiassian, P.S. Mangat and Z. Hurych Applied Physics Letters 62, 2437 (1993)
[23] **Direct and Rb-promoted SiOₓ/β-SiC(100) interface formation**
   M. Riehl-Chudoba, P. Soukiassian, C. Jaussaud and S. Dupont Physical Review B 51, 14300 (1995).

## Revendications

1. Ensemble de nano-objets (4, 10, 12, 22, 24), notamment de fils atomiques, de nano-structures unidimensionnelles et de plots quantiques, dans lequel les nano-objets sont faits d'un métal et formés sur la surface (2, 6, 14) d'un substrat en un matériau semiconducteur monocristallin, **caractérisé en ce que** la surface comporte des zones passivées (15) et des zones non passivées (16, 18) et les nano-objets sont formés sur ces zones non passivées de la surface.

2. Ensemble de nano-objets selon la revendication 1, dans lequel le matériau semiconducteur monocristallin est choisi parmi le carbure de silicium monocristallin, le diamant monocristallin, les semiconducteurs covalents monocristallins et les semiconducteurs composés monocristallins.

3. Ensemble de nano-objets selon la revendication 2, dans lequel le substrat est un substrat monocristallin de carbure de silicium en phase cubique.

4. Ensemble de nano-objets selon la revendication 3, dans lequel la surface (2) est une surface de carbure de silicium cubique, riche en silicium β-SiC(100)3x2.

5. Ensemble de nano-objets selon l'une quelconque des revendications 1 à 4, dans lequel les nano-objets sont des agrégats tridimensionnels (4) du métal sur la surface.

6. Ensemble de nano-objets selon la revendication 5, dans lequel les agrégats sont répartis de façon ordonnée sur la surface et forment ainsi un réseau de plots du métal.

7. Ensemble de nano-objets selon la revendication 3, dans lequel la surface (6, 14) est une surface de carbure de silicium cubique, terminée Si β-SiC(100) c(4x2), et les nano-objets sont des fils atomiques parallèles (10, 22) ou des bandes unidimensionnelles nanométriques parallèles (12, 24) du métal.

8. Ensemble de nano-objets selon la revendication 7, dans lequel la surface (6, 14) comporte des fils atomiques parallèles de Si (8, 20), les fils atomiques et les bandes unidimensionnelles du métal étant perpendiculaires à ces fils atomiques de Si.

9. Ensemble de nano-objets selon l'une quelconque des revendications 1 à 8, dans lequel le métal est choisi parmi les métaux dont la bande d est pleine, les métaux de type jellium, les métaux alcalins et les métaux de transition.

10. Ensemble de nano-objets selon la revendication 9, dans lequel le métal est choisi parmi le sodium et le potassium.

11. Procédé de fabrication d'un ensemble de nano-objets, dans lequel on prépare une surface(2, 6, 14) d'un substrat en un matériau semiconducteur monocristallin, on forme des zones passivées (15) sur la surface ainsi préparée et l'on dépose ensuite un métal sur des zones non passivées (16, 18) de cette surface.

12. Procédé selon la revendication 11, dans lequel le matériau semiconducteur monocristallin est choisi parmi le carbure de silicium monocristallin, le diamant monocristallin, les semiconducteurs covalents monocristallins et les semiconducteurs composés monocristallins.

13. Procédé selon la revendication 12, dans lequel le substrat est un substrat monocristallin de carbure de silicium en phase cubique.

14. Procédé selon la revendication 3, dans lequel la surface que l'on prépare est une surface (2) de carbure de silicium cubique, riche en silicium β-SiC(100) 3x2.

15. Procédé selon la revendication 3, dans lequel la surface que l'on prépare est une surface (6, 14) de carbure de silicium terminée Si β-SiC(100) c(4x2), on dépose le métal à température ambiante, et l'on obtient, par migration de surface des atomes de métal le long de rangées de dimères Si-Si de la surface c(4x2), des fils atomiques du métal, qui sont parallèles aux rangées de dimères Si-Si.

16. Procédé selon la revendication 15, dans lequel on effectue un recuit thermique du substrat à une température inférieure à la température de désorption totale du métal.

17. Procédé selon l'une quelconque des revendications 11 à 16, dans lequel le métal est choisi parmi le sodium et le potassium.

18. Procédé selon la revendication 13, dans lequel la surface est une surface terminée C de type sp, à savoir la surface β-SiC(100)c(2x2).

19. Procédé selon la revendication 18, dans lequel cette surface comprend des lignes atomiques de C de type sp3 et l'on forme des fils atomiques de métal qui sont soit parallèles, soit perpendiculaires aux lignes atomiques de C.
